# FASCICULE DE BREVET EUROPEEN

(11) **EP 1 673 932 B1**
(45) Date de publication et mention de la délivrance du brevet: **30.09.2009**
(21) Numéro de dépôt: 04791216.7
(22) Date de dépôt: 13.10.2004
(51) Int. Cl.: H04N 3/15

(54) **PROCEDE DE COMMANDE D UN DISPOSITIF PHOTOSENSIBLE**
STEUERVERFAHREN FÜR EINE LICHTEMPFINDLICHE EINRICHTUNG
CONTROL METHOD FOR A PHOTOSENSITIVE DEVICE

(30) Priorité: 17.10.2003 FR 0312183
(43) Date de publication de la demande: 28.06.2006
(73) Titulaire: Trixell S.A.S., 38430 Moirans (FR)
(72) Inventeur: APARD, Paul, THALES Intellectual Property, F-94117 ARCUEIL (FR); COUDER, David, THALES Intellectual Property, F-94117 ARCUEIL (FR)
(74) Mandataire: Collet, Alain
(86) Numéro de dépôt international: PCT/EP2004/052526
(87) Numéro de publication internationale: WO 2005/036871

(56) Documents cités:
- EP-A- 0 517 303
- FR-A- 2 770 954
- US-A- 5 668 375

## Description

La présente invention concerne un procédé de commande d'un dispositif photosensible comportant une matrice de points photosensibles du type notamment réalisé par des techniques de dépôt de matériaux semiconducteurs. L'invention concerne plus particulièrement (mais non exclusivement) la commande de tels dispositifs utilisés pour la détection d'images radiologiques.

Les techniques de dépôts en films minces de matériaux semiconducteurs tels que le silicium amorphe hydrogéné (aSiH), sur des supports isolants en verre par exemple, permettent de réaliser des matrices de points photosensibles pouvant produire une image à partir d'un rayonnement visible ou proche du visible. Pour utiliser ces matrices à la détection d'images radiologique, il suffit d'interposer entre le rayonnement X et la matrice, un écran scintillateur pour convertir le rayonnement X en rayonnement lumineux dans la bande de longueurs d'onde auxquelles les points photosensibles sont sensibles.

Les points photosensibles qui forment une telle matrice comprennent généralement un élément photosensible associé à un élément remplissant une fonction d'interrupteur. Le point photosensible est monté entre un conducteur de ligne et un conducteur de colonne de la matrice. Selon les besoins, le dispositif photosensible comporte alors une pluralité de points photosensibles agencés en matrice ou en barrette.

L'élément photosensible est couramment constitué par une diode, montée en série avec l'élément interrupteur. L'élément interrupteur peut être par exemple un transistor réalisé par les techniques de dépôt due films en couches minces. Ces techniques sont connues dans la littérature anglo-saxonne sous le nom de Thin Film Transistor (TFT). L'élément interrupteur peut également être une diode dite de commutation dont l'état " fermé " ou " passant " correspond à la polarisation qui la met en conduction directe, et dont l'état " ouvert " ou " bloqué " correspond à sa polarisation en inverse. Les deux diodes sont montées avec des sens de conduction opposés, dans une configuration dite " tête-bêche ". Une telle disposition est bien connue, notamment par la demande de brevet français 86 14058 (n° de publication 2 605 166) dans laquelle sont décrits, une matrice de points photosensibles du type à deux diodes en configuration " tête- bêche ", un procédé de lecture des points photosensibles, et une manière de réaliser un tel dispositif photosensible. Les composants formant la matrice sont réalisés à partir d'un matériau semi-conducteur amorphe qui produit de la rémanence. Ceci est lié à sa structure amorphe qui comporte un grand nombre de pièges, bien plus que dans les matériaux cristallins. Ces pièges sont des défauts de structure qui s'étendent sur toute la bande interdite. Ils retiennent des charges engendrées lors d'une prise d'image. Le matériau mémorise une image correspondant à une irradiation donnée et restitue des charges relatives à cette image au cours de la lecture de l'image suivante voire de plusieurs images suivantes. La qualité des images s'en ressent.

Pour essayer d'obtenir une image utile de qualité optimale, on effectue une correction de l'image utile à partir d'une image dite d'offset connue sous la dénomination française d'image noire généralement prise et stockée en début d'un cycle de fonctionnement. Cette image d'offset est l'image obtenue alors que le dispositif photosensible est exposé à un signal d'intensité nulle et correspond à une sorte d'image de fond. L'image d'offset varie en fonction de l'état électrique des composants des points photosensibles et de la dispersion de leurs caractéristiques électriques. L'image utile est celle lue alors que le dispositif photosensible a été exposé à un signal utile qui correspond à une exposition à un rayonnement X. Elle englobe l'image d'offset. La correction consiste à effectuer une soustraction entre l'image utile et l'image d'offset.

Pour réaliser une image utile ou une image d'offset on réalise un cycle d'images, c'est à dire une suite formée par une phase de prise d'image suivie d'une phase de lecture puis d'une phase d'effacement et de réinitialisation comme expliqué dans la demande de brevet FR-A-2 760 585. Durant la phase de prise d'image, les points photosensibles sont exposés à un signal à capter que ce signal soit un éclairement maximum ou l'obscurité. Durant la phase de lecture une impulsion de lecture est appliquée aux conducteurs ligne adressés pour lire la quantité de charges accumulée lors de la prise d'image. Durant la phase d'effacement les points photosensibles sont effacés, généralement optiquement au moyen d'un flash de lumière uniformément réparti sur l'ensemble des points photosensibles. Durant la phase de réinitialisation, les points photosensibles sont remis dans un état dans lequel ils sont réceptifs à une nouvelle prise d'image. Cette remise en état s'effectue en rendant temporairement l'élément interrupteur, diode de commutation ou transistor, conducteur au moyen d'une impulsion électrique envoyée sur des conducteurs ligne permettant l'adressage de la matrice.

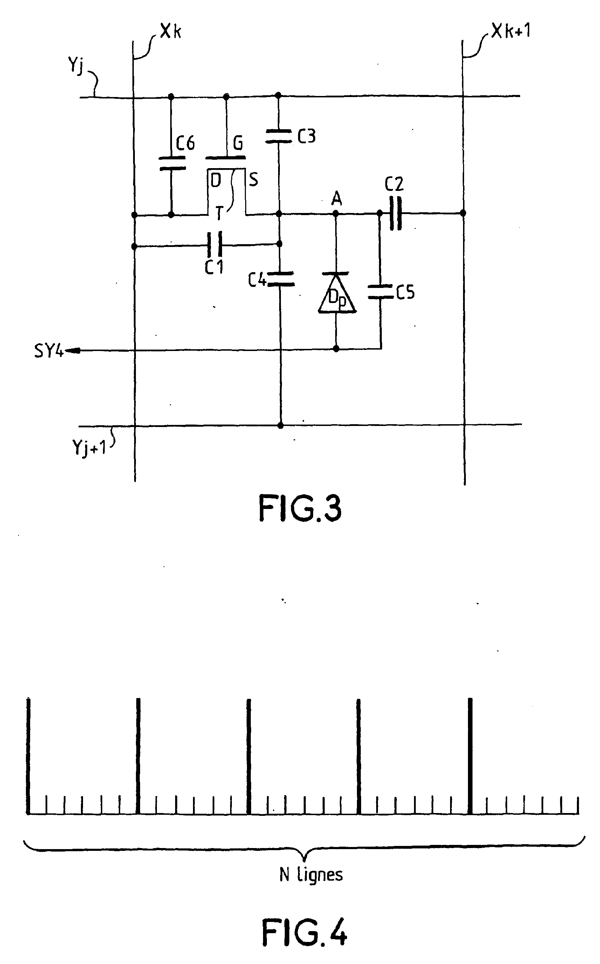

Jusqu'à présent on a réalisé la réinitialisation des points photosensibles d'une matrice en générant une seule impulsion électrique simultanément pour tous les points photosensibles de la matrice au travers des conducteurs ligne de la matrice. Malheureusement les points photosensibles ne sont pas parfaits. Ils sont soumis à des éléments parasites dont une modélisation sera présentée plus loin à l'aide de la figure 3. Ces éléments parasites sont essentiellement des couplages capacitifs. Les fronts de l'impulsion électrique envoyée sur les conducteurs ligne de la matrice pour rendre conducteur les éléments interrupteurs créent des injections de charges sur des conducteurs colonne de la matrice. Le front ouvrant l'élément interrupteur est critique. Les charges crées sur les conducteurs colonne par ce front ne peuvent s'évacuer qu'au travers de circuits de lecture raccordés aux conducteurs colonne. Ces charges mettent un certain temps à s'évacuer et provoquent donc temporairement une variation de tension sur chaque conducteur colonne. Cette variation de tension intervient au moment où l'isolement du point photosensible se réalise. Plus précisément, c'est le moment où se fixe le potentiel du point commun A entre la photodiode et l'élément interrupteur. Ce potentiel est essentiel car c'est lui qui évolue durant la phase de prise d'image sous l'effet du rayonnement lumineux reçu par la photodiode. Ce potentiel est donc fonction de la tension du conducteur colonne correspondant à l'instant précis où l'élément interrupteur s'ouvre. La présence de cette tension sur le conducteur colonne entraîne un décalage moyen d'offset et donc une perte de dynamique dans l'image utile.

De plus, l'instant où l'élément interrupteur s'ouvre n'est pas rigoureusement identique pour l'ensemble des points photosensibles. Cet instant dépend de la dispersion des valeurs des tensions de seuil de chaque élément interrupteur ainsi que de la dispersion des éléments parasites. Ceci entraîne une dispersion de l'offset de chaque point photosensible.

On a tenté de réduire la tension du conducteur colonne d'une part en réduisant l'amplitude de l'impulsion électrique envoyée sur les conducteurs ligne au cours de la phase de réinitialisation par rapport à l'amplitude de l'impulsion électrique envoyée sur les conducteurs ligne au cours de la phase de lecture et d'autre part en allongeant le front ouvrant l'élément interrupteur pour que le temps de commutation de l'élément interrupteur soit plus long que le temps nécessaire à l'écoulement des charges dans les conducteurs colonne. Ce palliatif reste peu satisfaisant car il n'améliore que peu les problèmes rencontrés. De plus, du fait de la dissymétrie des impulsions entre la phase de réinitialisation et de la phase de lecture ce palliatif entraîne quelques défauts de stabilité d'offset.

Le document EP 0 517 303 décrit une matrice de détection d'image utilisée en radiologie X, notamment pour de l'imagerie en continue. Cette matrice comprend un dispositif de remise à zéro des lignes de la matrice entre une phase de lecture et une phase d'acquisition. Pour éviter d'envoyer vers les circuits de lecture simultanément un trop grand nombre de charges, la remise à zéro s'effectue par groupe de lignes. On constate des dyssimétries de charges entre des lignes adjacentes d'un même groupe et des lignes adjacentes de deux groupes distincts.

L'invention vise à pallier notablement les problèmes rencontrés et à cet effet, l'invention a pour objet un procédé de commande d'un dispositif photosensible selon la revendication 1.

L'invention sera mieux comprise et d'autres avantages apparaîtront à la lecture de la description détaillée d'un mode de réalisation de l'invention donné à titre d'exemple, mode de réalisation illustré par le dessin joint dans lequel :
- les figures 1 et 2 représentent des dispositifs photosensibles auxquels peut s'appliquer l'invention ;
- ia figure 3 représente une modélisation d'éléments parasites présents pour des points photosensibles contigus d'un dispositif selon la figure 2 ;
- la figure 4 représente la répartition des lignes d'un groupe de lignes pour lequel on effectue simultanément la remise à zéro des points photosensibles.

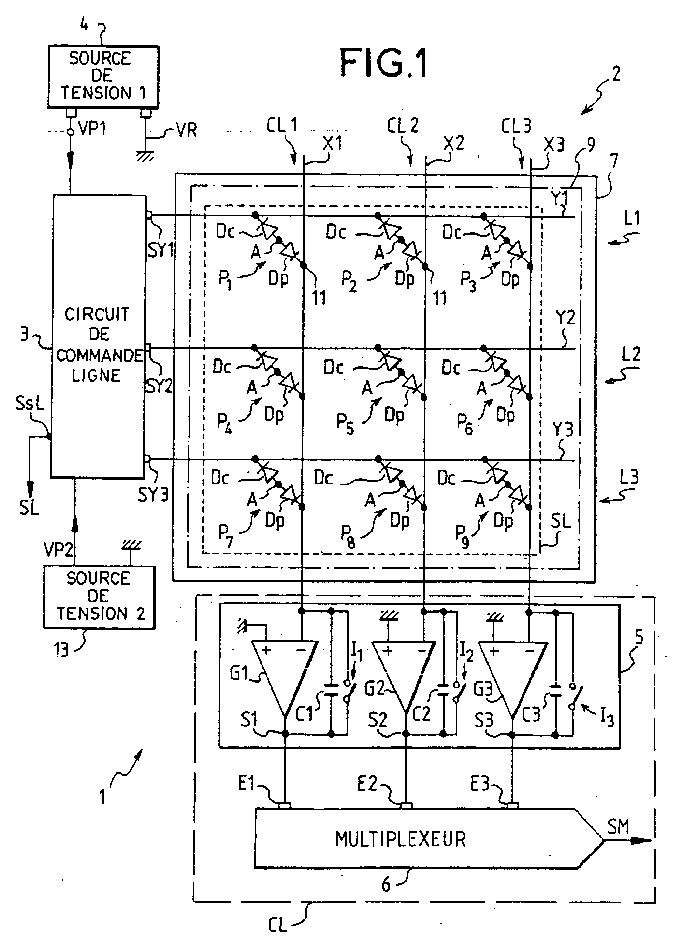

La figure 1 représente un schéma simplifié d'un dispositif photosensible 1, comportant une matrice 2 organisée de façon classique. La matrice 2 comporte des points photosensibles P1 à P9, formés chacun par une diode photosensible Dp et une diode de commutation Dc montées en série suivant une configuration tête-bêche. La matrice comporte des conducteurs ligne Y1 à Y3 croisés avec des conducteurs colonne X1 à X3, avec à chaque croisement, un point photosensible connecté entre un conducteur ligne et un conducteur colonne. Les points photosensibles P1 à P9 sont ainsi disposés suivant des lignes L1 à L3 et des colonnes CL1 à CL3.

Dans l'exemple de la figure 1, seulement 3 lignes et 3 colonnes sont représentées qui définissent 9 points photosensibles, mais une telle matrice peut avoir une capacité beaucoup plus grande, pouvant aller jusqu'à plusieurs millions de points. Il est courant par exemple de réaliser de telles matrices ayant des points photosensibles disposés suivant 3000 lignes et 3000 colonnes (dans une surface de l'ordre de 40 cm x 40 cm), ou bien disposés suivant une unique colonne et plusieurs lignes pour constituer une barrette de détection.

Le dispositif photosensible comporte un circuit de commande ligne 3, dont des sorties SY1, SY2, SY3 sont reliées respectivement aux conducteurs ligne Y1, Y2, Y3. Le circuit de commande ligne 3 dispose de différents éléments (non représentés), tels que par exemple, circuit d'horloge, circuits de commutation, registre à décalage, qui lui permettent de réaliser un adressage séquentiel des conducteurs lignes Y1 à Y3. Le dispositif photosensible comporte en outre une source de tension 4, délivrant au circuit de commande ligne 3 une tension VP1 servant à définir l'amplitude d'impulsions de polarisation appliquées aux conducteurs lignes et une source de tension 13, délivrant au circuit de commande ligne 3, une tension VP2 servant à définir l'amplitude d'impulsions de lecture appliquées aux conducteurs lignes. Ces deux sources de tension peuvent éventuellement être confondues.

Dans chaque point photosensible P1 à P9, les deux diodes Dp, Dc sont reliées entre elles soit par leur cathode, soit par leur anode comme dans l'exemple représenté. La cathode de la photodiode Dp est reliée à un conducteur colonne X1 à X3, et la cathode de la diode de commutation Dc est reliée à un conducteur ligne Y1 à Y3.

Dans la phase d'acquisition d'image ou de prise d'image, c'est-à-dire d'éclairement de la matrice 2 par un signal lumineux dit " utile ", les deux diodes Dp, Dc de chaque point photosensible P1 à P9 sont polarisées en inverse, et dans cet état elles constituent chacune une capacité. Il est à noter que généralement les deux diodes Dp, Dc sont conçues pour que la capacité présentée par la photodiode Dp soit la plus forte (de l'ordre par exemple de 50 fois).

Lors de l'exposition à un signal lumineux utile, des charges sont engendrées dans la photodiode Dp par l'éclairement du point photosensible P1 à P9 auquel elle appartient. Ces charges dont la quantité est fonction de l'intensité d'éclairement, s'accumulent en un point " A " sur le noeud (flottant) formé au point de jonction des deux diodes Dp, Dc. La lecture des points photosensibles P1 à P9 s'effectue ligne par ligne, simultanément pour tous les points photosensibles reliés à un même conducteur ligne Y1 à Y3. A cet effet, le circuit de commande ligne 3 applique à chaque conducteur ligne Y1 à Y3 adressé, une impulsion dite de lecture d'une amplitude donnée ; les conducteurs lignes qui ne sont pas adressés sont maintenus à un potentiel de référence Vr ou potentiel de repos, qui est la masse par exemple, et qui peut être le même potentiel que celui qui est appliqué aux conducteurs colonne X1 à X3.

L'éventuelle accumulation de charges au point " A " d'un point photosensible P1 à P9, entraîne en ce point une diminution de la tension, c'est-à-dire une diminution de la tension de polarisation inverse de la photodiode Dp. Avec certains modes de fonctionnement, l'application de l'impulsion de lecture à un conducteur ligne Y1 à Y3 a pour effet de restituer au potentiel du point " A " de tous les points photosensibles reliés à ce conducteur ligne, le niveau de polarisation qu'il possédait avant l'exposition au signal lumineux utile : il en résulte une circulation dans chacun des conducteurs colonne X1 à X3, d'un courant proportionnel aux charges accumulées au point " A " correspondant.

Les conducteurs colonne X1 à X3 sont reliés à un circuit de lecture CL, comprenant dans l'exemple un circuit intégrateur 5, et un circuit multiplexeur 6 formé par exemple d'un registre à décalage à entrées parallèles et sortie série. Chaque conducteur colonne est relié à une entrée négative " - " d'un amplificateur G1 à G3 monté en intégrateur. Une capacité d'intégration C1 à C3 est montée entre l'entrée négative " - " et une sortie S1 à S3 de chaque amplificateur. La seconde entrée " + " de chaque amplificateur G1 à G3 est reliée à un potentiel qui dans l'exemple est le potentiel de référence Vr, potentiel qui par suite est imposé à tous les conducteurs colonne X1 à X3._Chaque amplificateur comporte un élément interrupteur I1 à I3 dit de remise à zéro (constitué par exemple par un transistor du type MOS), monté en parallèle avec chaque capacité d'intégration C1 à C3.

Les sorties S1 à S3 des amplificateurs sont reliées aux entrées E1 à E3 du multiplexeur 6. Cette disposition classique permet de délivrer " en série " et ligne après ligne, (L1 à L3) en sortie SM du multiplexeur 6, des signaux qui correspondent aux charges accumulées aux points " A " de tous les points photosensibles P1 à P9.

Il est à noter qu'il est connu aussi, pour remplir la fonction d'interrupteur qui, dans l'exemple de la figure 1, est tenue par la diode de commutation Dc, d'utiliser un transistor ; ce dernier présente par rapport à la diode une plus grande complexité de connexion, mais il offre des avantages dans la qualité de son état " passant ", avantages qui seront évoqués dans la suite de la description.

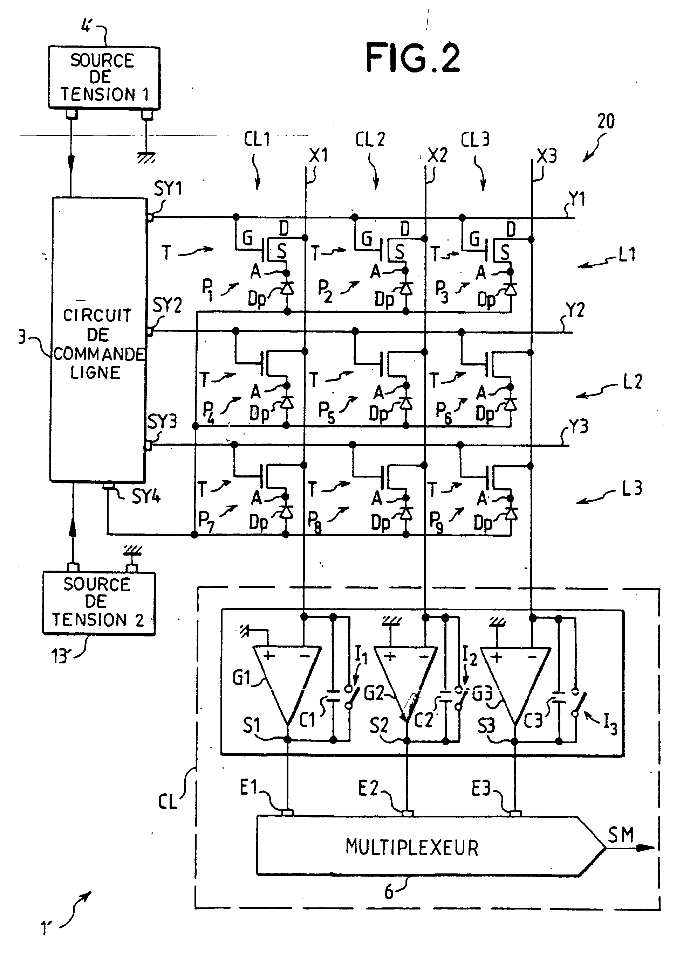

La figure 2 illustre schématiquement un dispositif photosensible 1' qui diffère de celui de la figure 1, principalement en ce qu'il comporte une matrice 20 dans laquelle les diodes de commutation Dc, sont remplacées par des transistors T par exemple réalisés par les techniques de dépôt de films en couches minces. Ces techniques sont connues dans la littérature anglo-saxonne sous le nom de Thin Film Transistor (TFT). Ces techniques peuvent également être utilisées pour réaliser la matrice 2 représentée figure 1.

Dans le schéma montré à la figure 2 à titre d'exemple, dans chaque point photosensible P1 à P9, le transistor T est relié par sa source S à la cathode de la photodiode Dp c'est-à-dire au point " A ", sa grille G est reliée au conducteur ligne Y1 à Y3 auquel appartient le point photosensible, et son drain D est relié au conducteur colonne X1 à X3 auquel appartient le point photosensible. Les anodes de toutes les photodiodes Dp sont réunies, et reliées à une sortie SY4 du circuit de commande ligne 3. La sortie SY4 délivre une tension dite de polarisation Vpolar, négative par rapport au potentiel de référence VR ou masse, de l'ordre par exemple de -5 volts, qui sert à constituer la polarisation en inverse des photodiodes Dp ; le circuit de commande ligne 3 reçoit par exemple cette tension de polarisation d'une source d'alimentation 4'.

Pour mieux comprendre le fonctionnement général des dispositifs représentés aux figures 1 et 2, on peut se reporter à la demande de brevet français publiée sous le n° FR 2 760 585.

La figure 3 représente une modélisation d'éléments parasites, essentiellement des condensateurs, présents autour d'un point photosensible tel que décrit à partir de la figure 2. Il est bien entendu que des éléments parasites de même nature existent aussi avec une matrice telle que représentée sur la figure 1. Le point photosensible représenté sur la figure 3 est situé entre les conducteurs ligne Yj et Yj+1 ainsi qu'entre les conducteurs colonne Xk et Xk+1. Six condensateurs C1 à C6 modélisent les éléments parasites associés au point photosensible. Le condensateur C1 relie la source S du transistor T et le conducteur colonne Xk. Le condensateur C2 relie la source S du transistor T et le conducteur colonne Xk+1. Le condensateur C3 relie la source S du transistor T et le conducteur ligne Yj. Le condensateur C4 relie la source S du transistor T et le conducteur ligne Yj+1. Le condensateur C5 relie la source S du transistor T et l'anode de la photodiode Dp. Le condensateur C6 relie le drain D du transistor T et le conducteur ligne Yj.

Ces éléments parasites perturbent le fonctionnement d'un cycle d'image. De plus la valeur des éléments parasites varie d'un point photosensible à un autre.

Dans le procédé de l'invention, les lignes de la matrice sont réparties en plusieurs groupes, et durant la phase de réinitialisation, on remet à zéro simultanément toutes les lignes d'un même groupe. Les différents groupes de lignes sont remis à zéro successivement et pas simultanément. Plus précisément le procédé consiste à attendre que la remise à zéro d'un groupe soit terminée avant de commencer la remise à zéro d'un autre groupe. La remise à zéro de l'ensemble de la matrice se fait séquentiellement. On diminue ainsi le nombre de charges induites sur les conducteurs colonnes. Ces charges s'évacuent donc plus facilement dans les conducteurs colonnes par le circuit de lecture CL. Ainsi le potentiel du point commun A entre le transistor T ou la diode photosensible Dp et la diode de commutation Dc est moins perturbé par le potentiel des conducteurs colonne. Avantageusement, les groupes de lignes ont sensiblement le même nombre de lignes. Ainsi le nombre de charges induites sur les conducteurs colonnes est sensiblement le même lors de toutes les opérations élémentaires de remise à zéro effectuées pour chacun des groupes de lignes. Par exemple, si le nombre total de lignes de la matrice est N et le nombre de lignes par groupe est n, le nombre de charges induites sur les conducteurs colonnes est réduit d'un facteur α = N/n . Le facteur α définit le nombre de groupes. Le nombre n de lignes par groupe doit être assez petit pour que l'on puisse conserver une amplitude suffisante pour l'impulsion électrique envoyée sur les conducteurs ligne du groupe au cours de la phase de réinitialisation et si possible une amplitude identique à celle envoyée sur les conducteurs ligne lors de la phase de lecture. Le nombre n de lignes par groupe doit être assez grand pour que le temps consacré à l'ensemble des opérations élémentaires de remise à zéro reste faible. Autrement dit, α est choisi pour optimiser précision et rapidité.

Avantageusement, les n lignes d'un même groupe sont disjointes afin d'éviter les dissymétries de couplage. En effet, si les lignes d'un même groupe étaient contiguës, les couplages dus aux éléments parasites représentés sur la figure 3 seraient différents entre deux lignes voisines d'un même groupe et deux lignes voisines de deux groupes différents. Avantageusement, les lignes d'un même groupe sont séparées par au moins deux lignes n'appartenant pas au groupe considéré.

Avantageusement, le procédé consiste à enchaîner les opérations élémentaires de remise à zéro en peigne. Plus précisément, les n lignes formant un groupe sont espacées régulièrement suivant un pas égal à α = N/n . La répartition des lignes d'un groupe est représentée sur la figure 4 et forment un peigne. Les N lignes de la matrice sont représentées en trait de petite hauteur. Les lignes du premier groupe sont représentées en trait de plus grande hauteur et forment des dents du peigne. Pour chaque dent du peigne on effectue à un instant donné la remise à zéro. Pour réaliser la réinitialisation complète de la matrice, on déplace le peigne au moins α-1 fois afin de balayer l'ensemble des N lignes de la matrice et pour chaque déplacement du peigne on effectue une nouvelle opération élémentaire de remise à zéro. L'adressage des lignes d'un groupe de la matrice peut être réalisé au moyen d'un registre à décalage qui positionne un pointeur de tension d'adressage sur une ligne choisie pour être la première ligne du groupe. On positionne les n pointeurs de ligne du groupe en entrant une impulsion de chargement au registre à décalage tous les α coups d'horloge. Pendant l'adressage des lignes du groupe aucune impulsion n'est envoyée aux lignes.

Avantageusement, l'impulsion de lecture envoyée successivement à chaque ligne de la matrice durant la phase de lecture pour lire la quantité charges accumulées aux points photosensibles pendant la phase de prise d'image est sensiblement égale à l'impulsion de remise à zéro envoyée à toutes les lignes d'un même groupe. Cette identité des impulsions électriques de lecture et de remise à zéro associée au fait que les lignes d'un même groupe sont disjointes permet d'obtenir une bonne symétrie entre les perturbations résiduelles subies par chaque point photosensible durant les deux phases, lecture et remise à zéro. Ainsi les perturbations des deux phases se soustraient et leurs influences sur l'image tendent à disparaître.

## Revendications

1. Procédé de commande d'un dispositif photosensible (1, 1') comprenant une matrice (2, 20) de points photosensibles (P1 à P9) repartis aux intersections de lignes (SY1 à SY3) et de colonnes (X1 à X3) de la matrice (2, 20), consistant à soumettre la matrice (2, 20) à un cycle d'image comprenant une phase d'initialisation précédent une phase de prise d'image les lignes de la matrice (2, 20) étant réparties en plusieurs groupes, consistant, durant la phase d'initialisation, à remettre à zéro simultanément toutes les lignes d'un même groupe, consistant à remettre à zéro successivement chaque groupe de lignes et **caractérisé en ce que** toutes les lignes d'un même groupe sont disjointes et **en ce que** les lignes formant un groupe sont espacées régulièrement suivant un pas égal à α = N/n , où N est le nombre total de lignes de la matrice et n est le nombre de lignes par groupe et **en ce que** les groupes de lignes ont le même nombre de lignes.

2. Procédé selon la revendication 1, **caractérisé en ce que** les lignes d'un même groupe sont séparées par au moins deux lignes n'appartenant pas au groupe considéré.

3. Procédé selon l'une des revendications precédentes, **caractérisé en ce que** la répartition des lignes d'un groupe forme un peigne.

4. Procédé selon la revendication 3, **caractérisé en ce qu'**on déplace le peigne au moins α-1 fois afin de balayer l'ensemble des lignes de la matrice (2, 20).

5. Procédé selon l'une des revendications précédentes, **caractérisé en ce qu'**il consiste à attendre que la remise à zéro d'un groupe soit terminée avant de commencer la remise à zéro d'un autre groupe.

6. Procédé selon l'une des revendications précédentes, **caractérisé en ce que** la phase de prise d'image est suivie d'une phase de lecture pendant laquelle une première impulsion électrique est envoyée successivement à chaque ligne de la matrice, la première impulsion permettant de lire la quantité charges accumulées aux points photosensibles durant la phase de prise d'image, **en ce que** durant la phase d'initialisation une seconde impulsion électrique est envoyée à toutes les lignes d'un même groupe pour effectuer la remise à zéro des lignes du groupe et **en ce que** la première et la seconde impulsion sont sensiblement égales.

## Claims

1. Method of driving a photosensitive device (1, 1') comprising a matrix (2, 20) of photosensitive pixels (P1 to P9) distributed at the intersections of rows (SY1 to SY3) and columns (X1 to X3) of the matrix (2, 20), consisting in subjecting the matrix (2, 20) to an image cycle that includes a resetting phase prior to an image acquisition phase, the rows of the matrix (2, 20) being distributed in several groups, consisting, during the resetting phase, in resetting all the rows of any one group simultaneously and consisting in resetting each group of rows in succession and **characterized in that** all the rows in any one group are disjoint and **in that** rows forming a group are uniformly spaced apart with a pitch equal to α = N/n, where N is the total number of rows of the matrix and n is the number of rows per group, and **in that** the groups of rows have the same number of rows.

2. Method according to Claim 1, **characterized in that** the rows in any one group are separated by at least two rows that do not belong to the group in question.

3. Method according to either of the preceding claims, **characterized in that** the distribution of the rows of a group forms a comb.

4. Method according to Claim 3, **characterized in that** the comb is moved at least α-1 times so as to scan all of the rows of the matrix (2, 20).

5. Method according to one of the preceding claims, **characterized in that** it consists in waiting until the resetting of a group has been completed before starting to reset another group.

6. Method according to one of the preceding claims, **characterized in that** the image acquisition phase is followed by a read phase during which a first electrical pulse is sent in succession to each row of the matrix, the first pulse making it possible to read the quantity of charge stored in the photosensitive pixels during the image acquisition phase, **in that**, during the reset phase, a second electrical pulse is sent to all the rows in any one group, in order to reset the rows in the group, and **in that** the first and second pulses are substantially identical.

## Patentansprüche

1. Verfahren zur Steuerung einer lichtempfindlichen Vorrichtung (1, 1'), die eine Matrix (2, 20) von lichtempfindlichen Punkten (P1 bis P9) enthält, welche an den Kreuzungen von Zeilen (SY1 bis SY3) und Spalten (X1 bis X3) der Matrix (2, 20) verteilt sind, das darin besteht, die Matrix (2, 20) einem Bildzyklus zu unterziehen, der eine Initialisierungsphase enthält, die vor einer Bildaufnahmephase liegt, wobei die Zeilen der Matrix (2, 20) in mehrere Gruppen verteilt sind, das während der Initialisierungsphase darin besteht, gleichzeitig alle Zeilen der gleichen Gruppe auf Null zurückzustellen, das darin besteht, nacheinander jede Gruppe von Zeilen auf Null zurückzustellen und **dadurch gekennzeichnet, dass** alle Zeilen der gleichen Gruppe getrennt sind und dass die eine Gruppe formenden Zeilen einen regelmäßigen Abstand gemäß einer Teilung α = N/n haben, wobei N die Gesamtzahl von Zeilen der Matrix und n die Anzahl von Zeilen pro Gruppe ist, und dass die Gruppen von Zeilen die gleiche Anzahl von Zeilen haben.

2. Verfahren nach Anspruch 1, **dadurch gekennzeichnet, dass** die Zeilen der gleichen Gruppe um mindestens zwei Zeilen getrennt sind, die nicht zur betrachteten Gruppe gehören.

3. Verfahren nach einem der vorhergehenden Ansprüche, **dadurch gekennzeichnet, dass** die Verteilung der Zeilen einer Gruppe einen Kamm bildet.

4. Verfahren nach Anspruch 3, **dadurch gekennzeichnet, dass** der Kamm mindestens α-1 Mal verschoben wird, um die Gesamtheit der Zeilen der Matrix (2, 20) abzutasten.

5. Verfahren nach einem der vorhergehenden Ansprüche, **dadurch gekennzeichnet, dass** es darin besteht, abzuwarten, dass die Nullrückstellung einer Gruppe beendet ist, ehe die Nullrückstellung einer anderen Gruppe begonnen wird.

6. Verfahren nach einem der vorhergehenden Ansprüche, **dadurch gekennzeichnet, dass** auf die Bildaufnahmephase eine Ablesephase folgt, während der ein erster elektrischer Impuls nacheinander an jede Zeile der Matrix gesendet wird, wobei der erste Impuls es ermöglicht, die Menge von während der Bildaufnahmephase an den lichtempfindlichen Punkten angesammelten Ladungen abzulesen, dass während der Initialisierungsphase ein zweiter elektrischer Impuls an alle Zeilen der gleichen Gruppe gesendet wird, um die Nullrückstellung der Zeilen der Gruppe durchzuführen, und dass der erste und der zweite Impuls im Wesentlichen gleich sind.
